# EUROPEAN PATENT APPLICATION

(11) **EP 2 445 015 A1**
(43) Date of publication of application: **25.04.2012**
(21) Application number: 10789361.2
(22) Date of filing: 01.06.2010
(51) Int. Cl.: H01L 31/042

(54) **SOLAR CELL MODULE LAMINATED BODY AND METHOD FOR MANUFACTURING SAME**

(30) Priority: 17.06.2009 JP 2009144417
(71) Applicant: Fuji Electric Co., Ltd., Kawasaki-shi (JP)
(72) Inventor: NAMIKI, Yoichi, Kawasaki-shi Kanagawa 210-0856 (JP); EGOTA, Kazumi, Kawasaki-shi Kanagawa 210-0856 (JP); TANDA, Masayuki, Tokyo 141-0032 (JP)
(74) Representative: MERH-IP Matias Erny Reichl Hoffmann
(86) International application number: PCT/JP2010/059234
(87) International publication number: WO 2010/146986

(57) **Abstract**

The invention provides a solar cell module stacked member in which a pressure sensitive-type adhesive for bonding together a support member and a solar cell module is not photodegraded, and there is no concern of separation of the support member and the solar cell module. In a solar cell module stacked member in which a support member and a solar cell module having an internal solar cell element are stacked, the support member and the solar cell module are bonded together; the support member and the solar cell module are bonded together by a reaction hardening-type adhesive in an outer rim portion of the solar cell module irradiated with sunlight; and the support member and the solar cell module are bonded together by a pressure sensitive-type adhesive in a portion which is on the inside of the outer rim portion of the solar cell module and in which sunlight is blocked.

## Description

### TECHNICAL FIELD

This invention relates to a solar cell module stacked member in which a support member and a solar cell module are stacked, and a method for manufacturing such a member, and in particular relates to a configuration and a method for bonding a support member and a solar cell module.

### BACKGROUND ART

In order to install a solar cell module outdoors and obtain electric power, the solar cell module is required to be fixed to a building, frame, or other structure. To this end, the solar cell module is affixed to a metal plate, resin sheet, tile, or other support member, which is a portion of the structure, to form a solar cell module stacked member.

One specific stacked configuration employs stacking of a support member and a solar cell module by bonding. For example, in Patent Reference 1 described below, a stacked member is disclosed in which a solar cell panel and at least adiabatic material and a planar-shape plate material, provided on the rear-face side thereof, are integrated by a bonding layer to form a stacked member. Further, Patent Reference 2 discloses a configuration in which a metal roof and a solar cell panel are bonded using double-sided tape. And Patent Reference 3 discloses a configuration in which a reaction hardening-type adhesive near the outer periphery between a submodule and a substrate for a roof, and a pressure sensitive-type sheet-shape adhesive on the inside of the reaction hardening-type adhesive, are disposed.

Patent Reference 1: Japanese Patent Application Laid-open No. H9-119202
Patent Reference 2: Japanese Patent Application Laid-open No. H6-85306
Patent Reference 3: Japanese Patent Application Laid-open No. 2008-53419

Solar cell module stacked members with a solar cell module mounted on a support member by bonding include members having a structure which uses a double-sided adhesive sheet as a bonding layer between the support member and the solar cell module, and members having a structure which uses a adhesive. However, both types of member have unresolved problems.

In a solar cell module stacked member having a structure which uses double-sided adhesive sheet, because of the high viscosity of the adhesive of the double-sided adhesive sheet, complete close adhesion to irregularities existing in the support member surface or in the solar cell module surface is not possible, and consequently rainwater or other moisture may intrude into the interface with the double-sided adhesive sheet at the edge portions of the double-sided adhesive sheet, the area of this intrusion may gradually expand, and there is the possibility that the support member may separate from the solar cell module.

Further, even in a case in which rainwater or other moisture did not intrude into the interface between the support member and the solar cell module, in cold regions, there is the problem that moisture remaining at the edges of a double-sided adhesive sheet may freeze and expand, causing the solar cell module to be pushed up from the support member, resulting in separation.

Further, in the above-described Patent Reference 2, a joining portion of a solar cell panel and metal plate is bonded and fixed using double-sided tape, but in this structure, the entire joining portion is not subjected to waterproofing, so that there is the possibility that rainwater and similar may easily intrude into the edges of the double-sided tape and at the seams of the double-sided tape, and as time advances and depending on climate conditions, the joining portion may be separated.

On the other hand, in a solar cell module stacked member having a structure using an adhesive, during manufacturing a fixed amount of time is required until the adhesive reaches the hardened state, so that during this time some means of temporarily fixing the solar cell module to the support member is necessary, and there is the problem that manufacturing costs are increased.

Further, when a double-sided adhesive sheet with high elasticity is used, or an adhesive with high elasticity in the hardened state is used, upon installing the solar cell module stacked member outdoors where there are changes in temperature, there is the possibility that the double-sided adhesive sheet or the hardened adhesive material cannot accommodate differences in dimensional changes arising from the difference in thermal expansion rates of the solar cell module and the support member, so that the support member may be separated from the solar cell module.

Further, in a case where the solar cell module and support member are flexible, when the solar cell module stacked member is deformed, there is the possibility that the double-sided adhesive sheet or the hardened adhesive material cannot accommodate the deformation, so that the support member may be separated from the solar cell module.

On the other hand, if a double-sided adhesive sheet with low elasticity is used, or an adhesive having low elasticity in the hardened state is used, there is the problem that adhesion strength is insufficient and the bonding portion is easily deformed.

Further, as another serious problem in cases where a support member and a solar cell module are bonded to form a stacked member, due to irradiation of adhesive with sunlight, photodegradation of the adhesive may occur depending on the material, and there is the possibility that the support member and the solar cell module may be separated.
In Patent Reference 3, there is no indication that a material which is not subject to photodegradation due to irradiation with sunlight is used in portions irradiated with sunlight, or that portions which are in the shadow of a solar cell element are not irradiated with sunlight, and so materials which are degraded by irradiation by sunlight may be used. Patent Reference 3 describes materials suitable for use in bonding when bonding a submodule and a substrate for a roof.

### DISCLOSURE OF THE INVENTION

This invention was devised in order to resolve the above-described problems, and has as an object the provision of a solar cell module stacked member, obtained by using bonding to mount a solar cell module on a support member, for which there are no concerns of separation of the support member from the solar cell module due to irradiation with sunlight or intrusion of moisture, and with a structure enabling high productivity, as well as a method for manufacturing such a member.

In order to solve the above problems, a solar cell module stacked member of this invention is a solar cell module stacked member in which are stacked a support member and a solar cell module sealed with a transparent sealing agent and having an internal solar cell element, wherein the support member and the solar cell module are bonded together; the support member and the solar cell module are bonded together by a reaction hardening-type adhesive in an outer rim portion of the solar cell module, which transmits sunlight through the transparent sealing agent; and the support member and the solar cell module are bonded together by a pressure sensitive-type adhesive in a portion which is on the inside of the outer rim portion of the solar cell module and in which sunlight is blocked by the solar cell element.
In this invention, it is preferable that the reaction hardening-type adhesive and the pressure sensitive-type adhesive be disposed on the support member with a gap of 1 to 10 mm therebetween.
Further, in a solar cell module stacked member of this invention in which are stacked a support member and a solar cell module sealed with a transparent sealing agent and having an internal solar cell element, the support member and the solar cell module are bonded together; the support member and the solar cell module are bonded together by an acrylic system pressure sensitive-type adhesive in an outer rim portion of the solar cell module, which transmits sunlight through the transparent sealing agent; and the support member and the solar cell module are bonded together by a pressure sensitive-type adhesive in a portion which is on the inside of the outer rim portion of the solar cell module and in which sunlight is blocked by the solar cell element.
In this invention, it is preferable that the acrylic system pressure sensitive-type adhesive and the pressure sensitive-type adhesive be disposed on the support member with a gap of 1 to 10 mm therebetween.
In the above solar cell module stacked member, it is preferable that the support member and the solar cell module have flexibility.
Further, a method for manufacturing a solar cell module stacked member of this invention, to manufacture a solar cell module stacked member in which are stacked a support member and a solar cell module sealed with a transparent sealing agent and having an internal solar cell element, has a process of disposing a pressure sensitive-type adhesive on a portion of the support member such that the pressure sensitive-type adhesive is positioned at a portion which opposes the solar cell element and at which sunlight is blocked, and fixing the solar cell module onto the support member by means of the pressure sensitive-type adhesive; a process of disposing a reaction hardening-type adhesive in an outer rim portion irradiated with sunlight and not opposing the solar cell element, the outer rim portion being on the outside of the pressure sensitive-type adhesive between the solar cell module and the support member which are held at a constant interval by the pressure sensitive-type adhesive; and a process of hardening the reaction hardening-type adhesive while holding the interval between the solar cell module and the support member by means of the pressure sensitive-type adhesive, to bond the solar cell module and the support member.
In this invention, it is preferable that the reaction hardening-type adhesive and the pressure sensitive-type adhesive be disposed on the support member with a gap of 1 to 10 mm therebetween.
Further, a method for manufacturing a solar cell module stacked member of this invention, to manufacture a solar cell module stacked member in which are stacked a support member and a solar cell module sealed with a transparent sealing agent and having an internal solar cell element, has a process of disposing a pressure sensitive-type adhesive on a portion of the support member such that the pressure sensitive-type adhesive is positioned at a portion which opposes the solar cell element and at which sunlight is blocked; a process of disposing an acrylic system pressure sensitive-type adhesive in an outer rim portion irradiated with sunlight and not opposing the solar cell element, the outer rim portion being on the outside of the pressure sensitive-type adhesive; and a process of fixing the solar cell module onto the support member by means of the pressure sensitive-type adhesive and the acrylic system pressure sensitive-type adhesive.
In this invention, it is preferable that the acrylic system pressure sensitive-type adhesive and the pressure sensitive-type adhesive be disposed on the support member with a gap of 1 to 10 mm therebetween.
In the above solar cell manufacturing methods, it is preferable that the support member and the solar cell module have flexibility.
As the pressure sensitive-type adhesive, rubber-asphalt system adhesive sheet and butyl rubber system adhesive sheet are preferable.

By means of the inventions described in Claims 1 to 4, a solar cell module stacked member for which there are no concerns of separation of the support member from the solar cell module due to irradiation with sunlight or intrusion of moisture can be obtained with high productivity. In particular, by preventing the pressure sensitive-type adhesive from protruding into the portion on the side below the solar cell element from the outer rim portion which is irradiated with sunlight, there is the advantageous result that photodegradation of the pressure sensitive-type adhesive no longer occurs. The portion irradiated with sunlight is a member photodegradation of which is small even when irradiated with light, as in the cases of a reaction hardening-type adhesive and an acrylic system pressure sensitive-type adhesive. By means of the invention described in Claim 5, both the support member and the solar cell module have flexibility, and so the solar cell module stacked member also has flexibility, and the solar cell module stacked member can be easily installed on buildings having curved surfaces as well. Further, because there is flexibility, transportation in a curled shape is also possible, and use even in places where power is not easily obtained is also possible. Further, during manufacture of the solar cell module stacked member, there is the advantage that the solar cell module and pressure sensitive-type adhesive (double-sided adhesive sheet) can be pressed together and affixed using a roller. By means of the inventions described in Claims 6 and 8, there is the advantage that during installation of a solar cell module on a support member, for example a solar cell module in a rolled-up shape can be unrolled while bonding to the support member. In this case also, pressure sensitive-type adhesive is disposed on the side below the solar cell element, that is, immediately below the solar cell element, so that the irradiation with sunlight and degradation of the pressure sensitive-type adhesive is prevented.

### BRIEF DESCRIPTION OF THE DRAWINGS

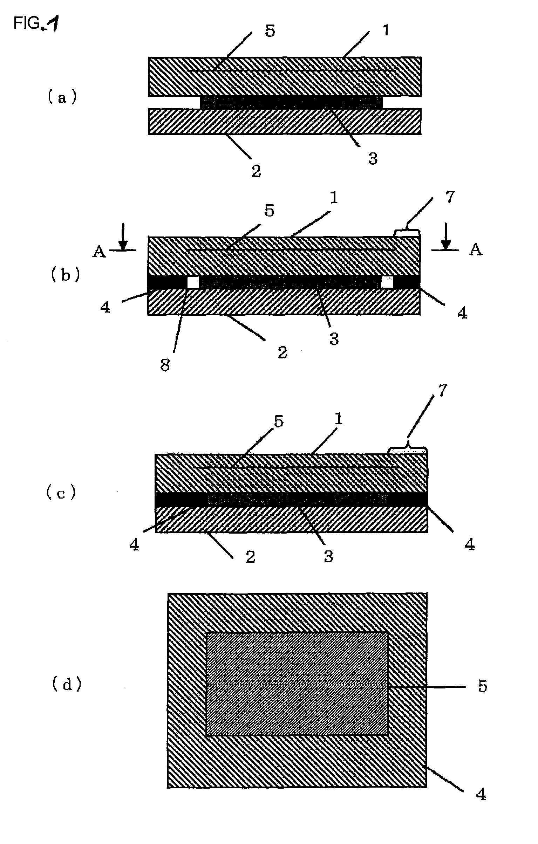

Fig. 1(a) is a cross-sectional view showing the temporarily fixed state of a solar cell module stacked member obtained in this invention, Fig. 1(b) is a cross-sectional view showing the fixed state of a solar cell module stacked member obtained in this invention, Fig. 1(c) is a cross-sectional view showing the fixed state of a solar cell module stacked member obtained in another mode of this invention, and Fig. l(d) is a plane view of the cross-section at AA of the solar cell module stacked member obtained in this invention; and

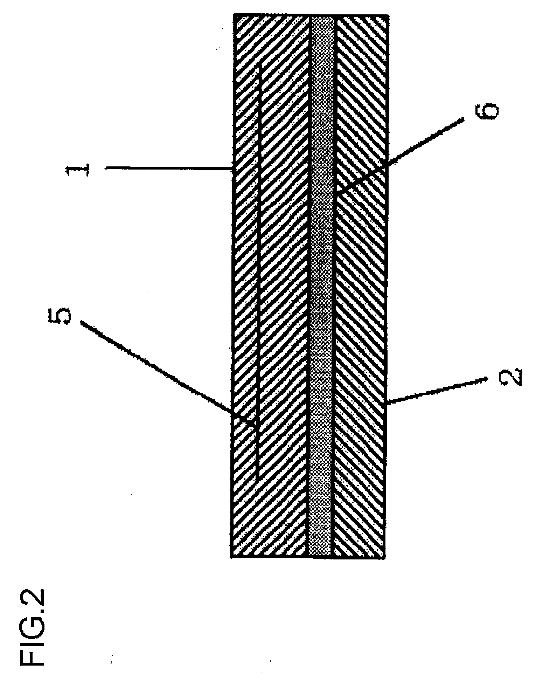

Fig. 2 is a cross-sectional view of a solar cell module stacked member obtained in an example of the prior art.

### BEST MODE FOR CARRYING OUT THE INVENTION

An embodiment of the invention is explained.
Figs. 1(a), 1(b) and 1(c) are cross-sectional views of one mode of the structure of a solar cell module stacked member of the invention, and Fig. 1(d) is a plane view of the cross section at A-A in Fig. 1(c).
Here, a pressure sensitive-type adhesive (double-sided adhesive sheet) 3 and reaction hardening-type adhesive 4 are inserted between the solar cell module 1 and the support member 2, to form the solar cell module stacked member. Within the solar cell module 1 is sealed a solar cell element 5. A pressure sensitive-type adhesive (double-sided adhesive sheet) 3 and acrylic system pressure sensitive-type adhesive may be inserted between the solar cell module 1 and support member 2, to form the solar cell module stacked member.

The solar cell module 1 may be rigid, or may have flexibility; the material on the bonding face thereof may be polyethylene, an ethylene-vinyl acetate copolymer, fluoride system resin, polyester resin or other polymer material, or a metal material. The support member 2 may be rigid, or may have flexibility; stainless steel sheet or other metal sheet, a fluoride resin or other resin sheet, tile, cloth, or similar can be used. The surfaces of these may be covered with a material other than the main material.

When the solar cell module and the support member are both flexible, affixing to a building having a curved face, such as for example a dome, a tent or similar, can easily be performed. And depending on the material of the support member, when the stacked member is rigid, installation on a building wall or the roof of a bus stop, public toilet or similar is possible, to effectively utilize the space to generate electric power. Depending on the material of the support member (for example, cloth with the surface covered by a thin resin or similar), the solar cell module stacked member can also be used as a tent or as construction material.

The surfaces of both the solar cell module 1 and the support member 2 can be subjected to corona discharge or plasma treatment, or can be coated with a primer, in order to enhance the adhesive force of the pressure sensitive-type adhesive 3 and reaction hardening-type adhesive 4 or acrylic system pressure sensitive-type adhesive 4.

The pressure sensitive-type adhesive 3 has an elasticity of 100 MPa or lower in order to absorb differences in dimensional changes due to differences in the thermal expansion rates of the solar cell module 1 and support member 2, as well as distortion and similar occurring when the flexible solar cell module stacked member is deformed, and to avoid destruction of the bonding interface. Moreover, in order to maintain bonding strength and avoid unwanted deformation of the solar cell module stacked member, it is preferable that the elasticity be 100 kPa or higher. As the material, a rubber asphalt system, butyl rubber system, or similar material can be used, and in order to enhance strength, enclosure in a film, netting or similar may be employed. As film, a polyethylene and polyester can be used. The film thickness is several tens to approximately 100 µm. As netting, polyester, nylon, or other thermoplastic polymer woven with a coarse mesh of approximately 5 to 10 mm is used. Unwoven cloth can also be used, employing mainly polyester or polypropylene material.
In the case of film, processes to manufacture film thinner than several tens of micrometers and processes for enclosure in film are attended with difficulty, and depending on the film material, there may be less of an effect in increasing the strength of the adhesive. If the thickness is greater than 100 µm, when stress in a bending direction is applied to pressure sensitive-type adhesive, the film may not be able to accommodate the bending, so that there is the concern that separation may occur at the interface between the pressure sensitive-type adhesive and the film.
In the case of netting, as opposed to film, the pressure sensitive-type adhesive passes through the mesh on both sides of the netting and fuses, and so there is the characteristic that destruction does not readily occur; but if the mesh is smaller than 5 mm this effect cannot be expected, and if the mesh is greater than 10 mm the effect of reinforcement is small.
One condition is that the netting thickness (strand thickness) be from 0.1 to 1 mm and not exceed 2/3 of the thickness of the adhesive. The lower limit is because at finer thicknesses the effect of reinforcement is minimal; the upper limit is because if the thickness is the same as or greater than the film, accommodation is not possible, and separation becomes a concern. Further, the condition that 2/3 of the adhesive thickness not be exceeded is because if this value is exceeded, a portion of the netting strands is exposed at the surface of the adhesive, and to this extent the contact area between the adhesive and the bonded objects (the solar cell module 1 and support member 2) is reduced, so that bonding strength is reduced.

The reaction hardening-type adhesive 4 has an object similar to that of the pressure sensitive-type adhesive 3, and so it is preferable that the elasticity thereof be 100 kPa or higher and 100 MPa or lower. As the material, a silicone system, acrylic system, epoxy system, or other material can be used; however, it is preferable that a silicone system material which exhibits little photodegradation be used. As the silicone system adhesive, a moisture curing-type adhesive, thermosetting-type adhesive, photosetting-type adhesive, or two-liquid mixture hardening-type adhesive can be used. The silicone system adhesive exhibits little degradation upon irradiation with light. An acrylic system pressure sensitive-type adhesive 4 also has no double bonds in its framework, and so there is no breaking of double bonds upon irradiation with light, and little photodegradation. As an acrylic system pressure sensitive-type adhesive 4, for example a foamy acrylic tape can be used.

Next, the structure of a solar cell module stacked member of this invention is explained in greater detail using Fig. 1.

A solar cell module 1 is bonded to a support member 2 with a pressure sensitive-type adhesive 3 therebetween. The pressure sensitive-type adhesive 3 is used in positions directly below the solar cell element. By means of this structure, that is, a structure in which adhesive does not protrude outside to the solar cell element, when the solar cell module stacked member is installed outdoors, adhesive is positioned immediately below the solar cell element, so that photodegradation of the pressure sensitive-type adhesive 3 due to irradiation by sunlight is prevented.

The solar cell module 1 sealed with a sealing agent is also bonded to the support member 2 with a reaction hardening-type adhesive 4 therebetween. Here, the reaction hardening-type adhesive 4 (for example, a silicone system adhesive) surrounds the outer rim of the pressure sensitive-type adhesive 3, and is applied in a shape which blocks the intrusion of moisture and similar from the outside. By means of this structure, intrusion of water into the pressure sensitive-type adhesive 3 is prevented. Further, the reaction hardening-type adhesive 4 undergoes little degradation upon irradiation with light.
Further, the solar cell module 1 may be bonded to the support member 2 with an acrylic system pressure sensitive-type adhesive 4 therebetween. The acrylic system pressure sensitive-type adhesive 4 (in particular, foamy acrylic tape) surrounds the outer rim of the pressure sensitive-type adhesive, and is applied in a shape which blocks intrusion of moisture and similar from the outside, preventing the intrusion of water into the pressure sensitive-type adhesive 3. As stated above, an acrylic system pressure sensitive-type adhesive has no double bonds in its framework, and so there is little degradation with irradiation of light.

Bonding by means of a pressure sensitive-type adhesive 3 and acrylic system pressure sensitive-type adhesive 4 does not require hardening and curing time, so there is the advantageous result that simultaneously with affixing, the solar cell module 1 is fixed to the support member 2. Hence even when a reaction hardening-type adhesive 4 is disposed on the outer rim portion, there is no need for temporary fixing by another special method or similar until the reaction hardening-type adhesive 4 hardens, and manufacturing efficiency is high.

Fig. 1(a) shows, for a case in which a reaction hardening-type adhesive 4 is disposed on the outer rim portion, the state in which the solar cell module 1 is temporarily fixed to the support member with the pressure sensitive-type adhesive (double-sided adhesive sheet) 3 therebetween. The solar cell module 1 and support member 2 are held at a fixed interval by the pressure sensitive-type adhesive 3. This interval is filled with the reaction hardening-type adhesive 4, and with the interval held unchanged, the adhesive 4 can be hardened (Fig. 1(b)).

Fig. 1(d) is a plane view of the cross-section A-A, seen from the side irradiated with sunlight, of the entirety of the solar cell module stacked member obtained in this invention. Because there is little photodegradation of the reaction hardening-type adhesive 4 or of the acrylic system pressure sensitive-type adhesive, problems do not occur even upon irradiation by sunlight. The solar cell element 5, besides a power generation function, acts to prevent irradiation of the pressure sensitive-type adhesive 3 by sunlight.

A panel-type module using a rigid member generally has a weight of approximately 15 to 20 kg per m², and is fixed in place with bolts after first reinforcing the roof or similar. On the other hand, in the case of a flexible solar cell module and support member, the weight is only approximately 1 kg per m², so fixing with a pressure sensitive-type adhesive 3 (adhesive sheet) and reaction hardening-type adhesive 4, or acrylic system pressure sensitive-type adhesive 4, is entirely possible, and fixing can be performed by simple means. However, even a panel-type module using a rigid member can be fixed by bonding according to the panel installation angle and similar by means of this invention.

By means of the configuration of this invention described above, a solar cell module stacked member with no possibility of separation can be manufactured with high productivity.

### Example

Next, an Example of the invention is described.
Fig. 1 shows a solar cell module stacked member which is an Example of the invention; Fig. 1(a) shows a state in which the module and support member are temporarily fixed by pressure sensitive-type adhesive, Fig. 1(b) shows a state in which the module and support member are fixed by the pressure sensitive-type adhesive 3 and by reaction hardening-type adhesive 4 or acrylic system pressure sensitive-type adhesive 4, and Fig. 1(d) is a plane view of a cross-section of Fig. 1(b) seen from the side having the solar cell element.

In order to obtain the state of Fig. 1(a), the solar cell module is installed on the pressure sensitive-type adhesive applied to the support member (in the case of an adhesive sheet, affixing rather than application is also possible); but when the solar cell module is flexible with a rolled-up shape, for example the solar cell module, wound onto a roller, can be unwound and placed in planar fashion on the support member.

In Fig. 1, a flexible module of thickness 0.85 mn is used as the solar cell module 1. Both the light-receiving face and the face opposite the light-receiving face of the solar cell element 5 are sealed with polyethylene. The material of the uppermost surface on the bonding face side is an ethylene-tetrafluoroethylene copolymer, the surface of which is plasma-treated. The support member 2 used flexible polyvinylidene fluoride-vinyl chloride trifluoride copolymer sheet of thickness 0.58 mm. As the double-sided adhesive sheet 3 which is the pressure sensitive-type adhesive, butyl rubber system double-sided adhesive sheet of thickness 0.8 mm was used. A moisture curing-type silicone system adhesive was used as the reaction hardening-type adhesive 4 which was the portion irradiated with light. Foamy acrylic tape was used as the acrylic system pressure sensitive-type adhesive 4 which was the portion irradiated with light. Using these members, two types of solar cell module stacked members, having the structure described in the embodiments section, were fabricated. In Fig. 1(b), a gap 8 is provided to some degree between the pressure sensitive-type adhesive 3 and the reaction hardening-type adhesive 4 or the acrylic system pressure sensitive-type adhesive 4; this is in order that the material of the pressure sensitive-type adhesive 3 and the material of the reaction hardening-type adhesive 4, or the acrylic system pressure sensitive-type adhesive 4, no be mixed together. If the pressure sensitive-type adhesive 3 and the acrylic system pressure-sensitive adhesive 4 or the acrylic system pressure sensitive-type adhesive 4 do not mix together, the gap 8 need not be present.
In the case of this Example, the outer side of the solar cell element 5 is the outer rim portion 7 as explained in Fig. 1 (b) .

It is preferable that the above-described gap 8 actually exist.
The reasons for this are as follows.
1) When the outer rim portion is a reaction hardening-type adhesive 4, in the stage until the reaction hardening is completed, the liquid-form adhesive is prevented from intruding into the interface between the pressure sensitive-type adhesive and the solar cell module 1 or support member 2 which is covered and inhibiting the bonding strength of the pressure sensitive-type adhesive.
2) When the outer rim portion is an acrylic system pressure sensitive-type adhesive, if the adhesive is affixed with the gap eliminated, if there is a slight shift in position in the stage of actual execution, a step may occur at a place at which the two types of pressure sensitive-type adhesive overlap, detracting from the overall bonding performance; a gap prevents this.
Further, it is preferable that this gap 8 exists in order that, when abnormal separation of one of the adhesives occurs, separation is not transmitted to the other adhesive.
The gap may be from 1 mm to 10 mm.
Further, the gap 8 may be filled with a silica gel or calcium oxide desiccant. This has the advantageous result of preventing the intrusion of moisture into the adhesives and causing separation.
When the outer rim portion employs acrylic system pressure sensitive-type adhesive, formation of the gap 8 can be properly executed by applying a ruler. Further, the amount of application of reaction hardening-type adhesive onto the outer rim portion can be controlled by "making the application cross-sectional area equal to the product of the thickness of the adhesive sheet and the width of extension in the outer rim portion". In both cases, by inserting a desiccant into the gap, a width of 1 to 10 mm can be secured.

Fig. 1(c) is a configuration example different from that of Fig. 1(b). As stated above, if the materials of the pressure sensitive-type adhesive 3 and the reaction hardening-type adhesive 4 or the acrylic system pressure sensitive-type adhesive 4 do not intermix, a gap 8 need not be provided therebetween, and so in Fig. 1(c) there is no gap 8. Further, the reaction hardening-type adhesive 4 or acrylic system pressure sensitive-type adhesive 4 may also exist on the side below the solar cell element 5, and so in Fig. 1(c), the reaction hardening-type adhesive 4 or acrylic system pressure sensitive-type adhesive 4 also exists on a portion below the solar cell element 5.
As shown in Fig. 1(c), in the case of this example a portion of the lower side of the solar cell element 5 is also an outer rim portion 7.
In manufacturing processes, during a period of one week until the reaction hardening-type adhesive 4 hardens, the solar cell module 1 was temporarily fixed to the support member 2 by the pressure sensitive-type adhesive 3, and therefore no other special method for temporary fixing was necessary, and high productivity was achieved. Further, when the outer rim portion is an acrylic system pressure-sensitive adhesive, when the pressure sensitive-type adhesive 3 and the acrylic system pressure sensitive-type adhesive 4 make contact with the applied objects (solar cell module 1 and support member 2), fixing is immediate, so that high productivity was achieved.

The solar cell module stacked member obtained exhibited no separation of the solar cell module 1 from the support member 2 or other abnormalities, even when rolled up into a tube shape of diameter 20 cm. One reason why this separation did not occur was that material with minimal photodegradation was installed at the outer rim portion 7 which is irradiated with sunlight, and the pressure sensitive-type adhesive 3, which does undergo photodegradation, was disposed directly below the solar cell element 5, such that there was no irradiation with light. Depending on the type of structure of the solar cell element 5, holes may be opened in the element substrate; but if the only light incident is that which passes through holes of this size, then there is no adverse effect of light on the pressure sensitive-type adhesive 3 immediately below the element.
The ability to roll up a module into a diameter of 20 cm is one advantage of this invention. With a diameter of 20 cm, a module can easily be transported by hand, and can easily be carried to places at which there is no electric power, such as for example when using the module as a power supply in mountain climbing. Modules can also be quickly transported to places where they are needed as an emergency power supply during power outages and similar.

Further, tests were also performed in which solar cell module stacked members thus obtained were installed outdoors for 12 months and exposed to sunlight. As a result, there was no separation of the solar cell modules 1 from the support members 2 or other abnormalities for either of the two types of solar cell module stacked members (the two types being those using a reaction hardening-type adhesive 4 in portions irradiated with light, and those using an acrylic system pressure sensitive-type adhesive 4 in portions irradiated with light); moreover, even when after this exposure to sunlight the solar cell stacked members were rolled up into tube shapes of diameter 20 cm, no separation of the solar cell modules 1 from the support members 2 or other abnormalities were observed.

### Comparative Example 1

In Fig. 2, the same solar cell module 1 and support member 2 as in the Example were used. The adhesive 6 was the same as the pressure sensitive-type adhesive 3 used in the Example.

Upon installing the solar cell module stacked members obtained outdoors for 12 months and exposing to sunlight, water intruded at the interface between the adhesive 6 and the solar cell module 1 at the edges of the adhesive 6, and separation occurred. Further, separation of the interface between the adhesive 6 and the solar cell module also occurred due to degradation of the adhesive 6 caused by light irradiation.

### Comparative Example 2

In Fig. 2, the same solar cell module 1 and support member 2 as in the Example were used. The adhesive 6 was the same as the reaction hardening-type adhesive 4 used in the Example.

In manufacturing processes, during an interval of one week until hardening of the reaction hardening-type adhesive was completed, the solar cell module 1 was temporarily fixed to the support member 2 at a uniform interval, so that it was necessary to place numerous weights on the solar cell module 1, and moreover the member with the weights placed could not be moved until hardening ended, so that production efficiency was low.

### INDUSTRIAL APPLICABILITY

This invention provides a solar cell module stacked member, comprising a support member and a solar cell module, with no possibility of separation arising from material degradation of adhesive due to irradiation with sunlight or of separation due to intrusion of moisture, and productivity of which can be improved.

### EXPLANATION OF REFERENCE NUMERALS

- 1: solar cell module
- 2: support member
- 3: pressure sensitive-type adhesive
- 4: reaction hardening-type adhesive, acrylic system pressure sensitive-type adhesive
- 5: solar cell element
- 6: adhesive
- 7: outer rim portion
- 8: gap

## Claims

1. A solar cell module stacked member in which are stacked a support member and a solar cell module sealed with a transparent sealing agent and having an internal solar cell element, **characterized in that**:
the support member and the solar cell module are bonded together,
the support member and the solar cell module are bonded together by a reaction hardening-type adhesive in an outer rim portion of the solar cell module, which transmits sunlight through the transparent sealing agent, and
the support member and the solar cell module are bonded together by a pressure sensitive-type adhesive in a portion which is on the inside of the outer rim portion of the solar cell module and in which sunlight is blocked by the solar cell element.

2. The solar cell module stacked member according to Claim 1, **characterized in that** the reaction hardening-type adhesive and the pressure sensitive-type adhesive are disposed on the support member with a gap of 1 to 10 mm therebetween.

3. A solar cell module stacked member in which are stacked a support member and a solar cell module sealed with a transparent sealing agent and having an internal solar cell element, **characterized in that:**
the support member and the solar cell module are bonded together,
the support member and the solar cell module are bonded together by an acrylic system pressure sensitive-type adhesive in an outer rim portion of the solar cell module, which transmits sunlight through the transparent sealing agent, and
the support member and the solar cell module are bonded together by a pressure sensitive-type adhesive in a portion which is on the inside of the outer rim portion of the solar cell module and in which sunlight is blocked by the solar cell element.

4. The solar cell module stacked member according to Claim 3, **characterized in that** the acrylic system pressure sensitive-type adhesive and the pressure sensitive-type adhesive are disposed on the support member with a gap of 1 to 10 mm therebetween.

5. The solar cell module stacked member according to any one of Claims 1 to 4, **characterized in that** the support member and the solar cell module have flexibility.

6. A method for manufacturing a solar cell module stacked member in which are stacked a support member and a solar cell module sealed with a transparent sealing agent and having an internal solar cell element, comprising the steps of:
disposing a pressure sensitive-type adhesive on a portion of the support member such that the pressure sensitive-type adhesive is positioned at a portion which opposes the solar cell element and at which sunlight is blocked, and fixing the solar cell module onto the support member by means of the pressure sensitive-type adhesive;
disposing a reaction hardening-type adhesive in an outer rim portion irradiated with sunlight and not opposing the solar cell element, the outer rim portion being on the outside of the pressure sensitive-type adhesive between the solar cell module and the support member which are held at a constant interval by the pressure sensitive-type adhesive; and
hardening the reaction hardening-type adhesive while holding the interval between the solar cell module and the support member by means of the pressure sensitive-type adhesive, to bond the solar cell module and the support member.

7. The method for manufacturing a solar cell module stacked member according to Claim 6, **characterized in that** the reaction hardening-type adhesive and the pressure sensitive-type adhesive are disposed on the support member with a gap of 1 to 10 mm therebetween.

8. A method for manufacturing a solar cell module stacked member in which are stacked a support member and a solar cell module sealed with a transparent sealing agent and having an internal solar cell element, comprising the steps of:
disposing a pressure sensitive-type adhesive on a portion of the support member such that the pressure sensitive-type adhesive is positioned at a portion which opposes the solar cell element and at which sunlight is blocked;
disposing an acrylic system pressure sensitive-type adhesive in an outer rim portion irradiated with sunlight and not opposing the solar cell element, the outer rim portion being on the outside of the pressure sensitive-type adhesive; and
fixing the solar cell module onto the support member by means of the pressure sensitive-type adhesive and the acrylic system pressure sensitive-type adhesive.

9. The method for manufacturing a solar cell module stacked member according to Claim 8, **characterized in that** the acrylic system pressure sensitive-type adhesive and the pressure sensitive-type adhesive are disposed on the support member with a gap of 1 to 10 mm therebetween.

10. The method for manufacturing a solar cell module stacked member according to any one of Claims 6 to 9, **characterized in that** the support member and the solar cell module have flexibility.
